# EUROPÄISCHE PATENTSCHRIFT

(11) **EP 1 923 999 B1**
(45) Veröffentlichungstag und Bekanntmachung des Hinweises auf die Patenterteilung: **28.04.2010**
(21) Anmeldenummer: 07020762.6
(22) Anmeldetag: 24.10.2007
(51) Int. Cl.: H03K 17/96

(54) **Bedienvorrichtung für ein Elektrogerät und Bedienverfahren**
Operating device for an electric device and operating method
Dispositif de commande pour un appareil électrique et procédé de commande

(30) Priorität: 14.11.2006 DE 102006054764
(43) Veröffentlichungstag der Anmeldung: 21.05.2008
(73) Patentinhaber: E.G.O. ELEKTRO-GERÄTEBAU GmbH, 75038 Oberderdingen (DE)
(72) Erfinder: Baier, Martin, 76275 Ettlingen (DE); Jungbauer, Markus, 76646 Bruchsal-Obergrombach (DE)
(74) Vertreter: Patentanwälte Ruff, Wilhelm, Beier, Dauster & Partner

(56) Entgegenhaltungen:
- EP-A- 0 725 482
- DE-U1-202005 019 978
- US-A- 4 233 593

## Beschreibung

### Anwendungsgebiet und Stand der Technik

Die Erfindung betrifft eine Bedienvorrichtung für ein Elektrogerät, beispielsweise ein Elektrowärmegerät wie ein Kochfeld, sowie ein Bedienverfahren dafür.

Eine ähnliche Bedienvorrichtung ist beispielsweise aus der DE 20 2005 019 978 U1 bekannt. Ein von einem Signalgeber unter der Auflage erzeugtes Signal wird kapazitiv an eine leitfähige Sensorfläche an der Unterseite des Bedienelements übertragen. Diese Sensorfläche ist elektrisch mit einer Berührungsfläche an eine Oberseite des Bedienelements verbunden. Wird die Berührungsfläche mit einem Finger berührt, so wird dadurch das daran anliegende Signal des Signalgebers verändert. Über die direkte Verbindung mit der Sensorfläche wird diese Signaländerung an den Signalgeber weitergegeben und kann ausgewertet werden.

Die US-A-4233593 beschreibt eine Bedienvorrichtung mit kapazitivem Funktionsprinzip. Dabei wird das kapazitive Funktionsprinzip allerdings nur dazu genutzt, die Drehstellung eines Bedienelementes zu erfassen.

Die EP-A-725482 beschreibt eine weitere Bedienvorrichtung mit kapazitivem Funktionsprinzip. Auch hier wird eine Relativposition zweier zueinander bewegbarer Teile durch variierente kapazitive Kopplung erfasst.

### Aufgabe und Lösung

Der Erfindung liegt die Aufgabe zugrunde, eine eingangs genannte Bedienvorrichtung sowie ein entsprechendes Bedienverfahren zu schaffen, mit denen Nachteile des Standes der Technik vermieden werden können und insbesondere eine Bedienung erkannt und ausgewertet werden kann.

Gelöst wird diese Aufgabe durch eine Bedienvorrichtung mit den Merkmalen des Anspruchs 1 sowie ein Bedienverfahren mit den Merkmalen des Anspruchs 11. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zu Inhalt der Beschreibung gemacht.

Es ist vorgesehen, dass die Bedienvorrichtung ein bewegbares Bedienelement aufweist, das abnehmbar ist und mit einer Bedienelement-Unterseite auf einer Auflage aufliegt. Es ist eine berührungslose und vorteilhaft kapazitive Signalkopplung zwischen Sensorflächen unten an dem Bedienelement und Signalgebern an oder unter der Auflage vorgesehen. Die Sensorflächen sind mit Berührungsflächen oben an dem Bedienelement verbunden, die von einer Bedienperson berührt und ausgelöst bzw. bedient werden können für eine Bedienfunktion. Dabei ist vorteilhaft jede Sensorfläche mit einer Berührungsfläche verbunden. Mehrere Signalgeber bzw. die Signalgeber sind entlang eines Kreises an der Auflage angeordnet, wobei die Sensorflächen auf einem dazu entsprechend konzentrischen Kreis am Bedienelement angeordnet sind. Erfindungsgemäß sind mehr Sensorflächen als Signalgeber vorgesehen. Damit ist es möglich, bei einem drehbaren Bedienelement unabhängig von der relativen Drehstellung des Bedienelements an einer absolut festgelegten Stelle eine Berührungsfläche zu berühren, was durch die sozusagen weniger fein verteilten Signalgeber erfasst werden kann. Dabei können Sensorflächen und Signalgeber so ausgebildet sein, dass eine Signalübertragung nicht nur dann erfolgt, wenn eine Sensorfläche genau über dem Signalgeber ist, sondern auch unter Umständen ein Stück seitlich versetzt ist oder sogar ohne Überdeckung genau eines Signalgebers, sondern zwischen zwei Signalgebern.

In Ausgestaltung der Erfindung können erheblich mehr Sensorflächen als Signalgeber vorgesehen sein, beispielsweise doppelt so viele oder sogar noch mehr. Es können dazu beispielsweise mindestens zehn oder zwölf Sensorflächen und auch Berührungsflächen vorgesehen sein, und beispielsweise nur vier Signalgeber. Die Flächen und die Signalgeber können vorteilhaft in Form kreisringsegmentartiger Flächen aus Metall oder leitfähigem Material vorliegen. Vor allem die Berührungsflächen und die Sensorflächen können besonders vorteilhaft in Form schmaler, radial verlaufender Streifen vorliegen. Sie können auch in Form durchgehend von der Oberseite des Bedienelements zu der Unterseite verlaufender Segmente bzw. Abschnitte vorliegen, die in einen Kunststoffkörper eingebettet sind. Damit sind die Berührungsflächen und die Sensorflächen sozusagen in einem Stück ausgebildet. Nach oben zu können die Berührungsflächen auch mit einer dünnen Abdeckung versehen sein, beispielsweise als Schutz oder zur Dekoration. Dies beeinträchtigt die Funktion nicht.

Es ist möglich, dass die Sensorflächen und auch die Berührungsflächen jeweils gleich verteilt angeordnet sind, also mit gleichen Abständen zueinander. Dasselbe kann für die Signalgeber gelten. Dabei sollten zwischen benachbarten Sensorflächen zumindest kleine Zwischenräume gegeben sein. Zwischen benachbarten Signalgebern sollten größere Zwischenräume gegeben sein, da vor allem durch diese größeren Zwischenräume zwischen den Signalgebern eine genauere Erkennung einer Position darüber befindlicher Sensorflächen möglich ist. Die Zwischenräume zwischen benachbarten Signalgebern können in einer Ausführung in etwa so groß sein wie die Breite eines Signalgebers selbst oder sogar größer. Vorteilhaft sind sie jedoch schmaler, so dass eine Sensorfläche immer mindestens einen Signalgeber zumindest teilweise überdeckt. So ist eine genaue Unterscheidung darüber liegender Sensorflächen und deren Erkennung möglich.

Vorteilhaft sind die Kreise, auf denen die Sensorflächen und die Signalgeber angeordnet sind, gleich groß und liegen somit übereinander. Besonders vorteilhaft sind diese Kreise etwas kleiner als der Außenumfang des Bedienelements, so dass vor allem die Sensorflächen innerhalb des Bedienelements und hierum wiederum innerhalb dessen Umrandung angeordnet sein können. Sie können nach unten mit einer Abdeckung versehen sein.

Gemäß einer Ausgestaltung der Erfindung ist es möglich, dass die Sensorflächen und die Signalgeber kapazitiv gekoppelt sind. Hierbei ist es vor allem vorteilhaft möglich, dass die Sensorflächen über die Berührungsflächen am Bedienelement durch einen an das Bedienelement bzw. die Berührungsflächen angelegten Finger einer Bedienperson elektrisch kontaktierbar sind. Hierzu sind die Berührungsflächen mit den Sensorflächen elektrisch verbunden. Die Berührung der Berührungsflächen am Bedienelement kann also von den kapazitiven Signalgebern aufgrund der kapazitiven Kopplung zwischen Sensorflächen und Signalgebern erfasst und erkannt werden, worauf eine entsprechend festgelegte Bedienfunktion ausgelöst werden kann. Dabei ist pro Sensorfläche eine Berührungsfläche vorgesehen.

Gemäß einem weiteren unabhängigen Erfindungsaspekt kann bei einer eingangs genannten Bedienvorrichtung mit den Merkmalen des Oberbegriffs des Anspruchs 1 ein Signalgeber für eine kapazitive Signalkopplung an der Auflage vorgesehen sein, der in länglicher Form oder Kreisringform ausgebildet ist als sogenannter kapazitiver Slider, wie er beispielsweise aus der DE 10 2004 044 355 A1 oder der US 2004/0104826 bekannt ist, auf die diesbezüglich ausdrücklich verwiesen wird. Dieser Slider zählt dann als ein Signalgeber. Dabei sind weiterhin mehrere Sensorflächen und Berührungsflächen an dem Bedienelement vorgesehen.

Bei einem vorteilhaften Bedienverfahren ist umfasst, dass bei einem Kochfeld mit mehreren Kochstellen als Elektrogerät zuerst eine der Berührungsflächen an dem Bedienelement berührt wird zur Auswahl einer Kochstelle über Feststellung der Berührung durch die Sensorfläche und den Signalgeber. Danach wird durch Bewegen des Bedienelementes, insbesondere Drehen, eine Leistungsstufe, Betriebsdauer oder Betriebsverzögerung für diese Kochstelle eingestellt. Mit dem Ort der ersten Berührung des Bedienelements erfolgt ein Selektieren.

Bei dem vorgenannten Verfahren ist es möglich, dass während des Bewegens des Bedienelementes, beispielsweise für die Leistungshöhe, die Berührungsfläche durch einen aufgelegten Finger weiterhin berührt bleibt. Es ist also weiterhin die ausgewählte Kochstelle in diesem Auswahlzustand zu halten. Gemäß einem alternativen Aspekt kann vorgesehen sein, dass die Berührungsfläche während des Bewegens des Bedienelementes nicht mehr berührt ist. Während in dem erstgenannten Fall sozusagen durch Betätigen und weiteres Berühren beim Bedienverfahren in eine nächste Ebene geschaltet wird, in der dann die Einstellung vorgenommen wird, wird bei dem zuletzt genannten Verfahren durch ein einmaliges kurzes Berühren bzw. Betätigen sozusagen in diese nächsthöhere Ebene geschaltet, wobei dann dieser Zustand nicht mehr aufrechterhalten werden muss.

In weiterer Ausgestaltung der Erfindung ist es auch möglich, die Drehung des Bedienelements zu erkennen. Dies kann auf einfache Art und Weise optisch erfolgen, wie es beispielsweise aus der DE 10330912 A1 bekannt ist, auf die diesbezüglich ausdrücklich Bezug genommen wird.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombination bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine seitliche Darstellung einer erfindungsgemäßen Bedienvorrichtung mit einer ersten Ausgestaltung des Bedienelements als Drehknebel,
- Fig. 2: eine Draufsicht von unten auf die Auflage mit als Kreisringsegmentflächen ausgebildeten Signalgebern,
- Fig. 3: eine Draufsicht auf die Unterseite des Bedienelements aus Fig. 1 mit kreisringsegmentartigen Flächen als Sensorflächen,
- Fig. 4: die Ansichten aus Fig. 2 und 3 kombiniert miteinander,
- Fig. 5: eine Draufsicht auf das Bedienelement aus Fig. 1 von oben mit Berührungsflächen, die mit den Sensorflächen elektrisch verbunden sind,
- Fig. 6: eine Variation eines Bedienelements in Draufsicht von oben mit den Berührungsflächen an dem Zentralteil und
- Fig. 7: eine Variation des Bedienelements von Fig. 3 mit feinerer Aufteilung in schmale Sensorflächen.

### Detaillierte Beschreibung der Ausführungsbeispiele

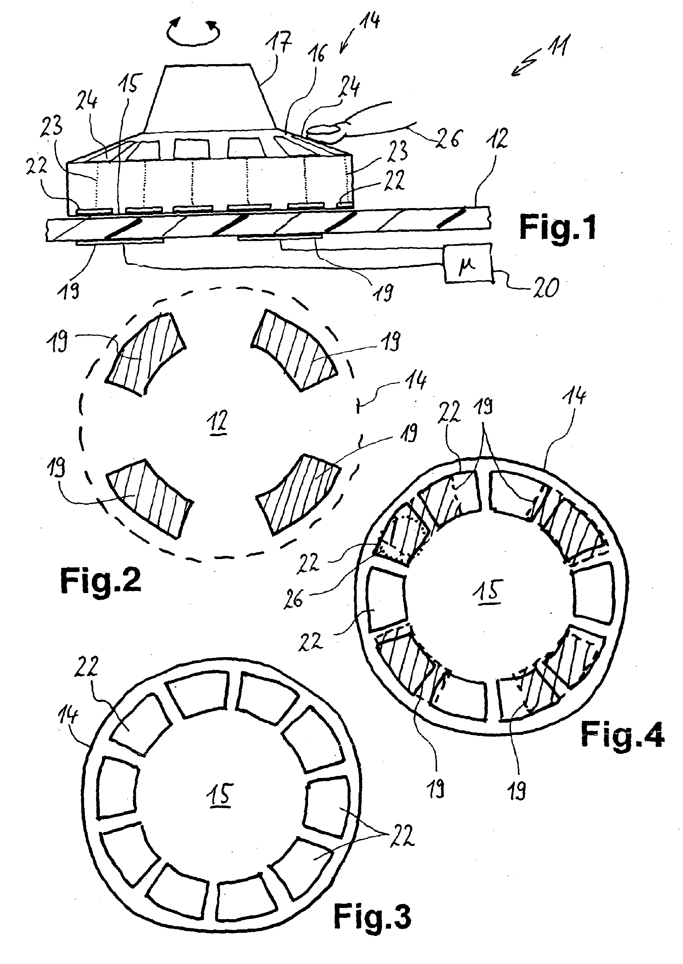

In Fig. 1 ist eine Bedienvorrichtung 11 dargestellt gemäß der Erfindung. Auf eine Auflage 12, die beispielsweise gemäß dem eingangs genannten Stand der Technik eine Kochfeldplatte eines Elektro-Kochfeldes aus Glaskeramik sein kann, ist ein Bedienelement 14 mit seiner Unterseite 15 aufgesetzt. Dessen Halterung über Magnetkraft odgl. ist aus dem Stand der Technik bekannt, beispielsweise der eingangs genannten DE 20 2005 019 978 U1. Darauf wird explizit verwiesen, so dass hier weitere Ausführungen entfallen können. Es geht hier um die Erkennung einer Drehbewegung bzw. Drehstellung. Neben der Unterseite 15 weist das Bedienelement 14 eine Oberseite 16 auf, welche zur Mitte hin leicht ansteigt und in der Mitte einen schmaleren, hochragenden Zentralteil 17 aufweist. Das Bedienelement kann jedoch auch die Form einer dicken, flachen Scheibe aufweisen.

Unter der Auflage 12 sind flächige bzw. flächenartige Signalgeber 19 vorgesehen, deren Anordnung in Fig. 2 dargestellt ist. Es sind vier Signalgeber 19 vorgesehen als kapazitive Sensorelemente bzw. metallische, kreisringsegmentartig ausgebildete Flächen, beispielsweise Metallplättchen. Diese sind jeweils mit einer Steuerung 20 verbunden zur Ansteuerung bzw. zur Auswertung. Die Anordnung des Bedienelements 14 oberhalb der Signalgeber 19 ist gestrichelt dargestellt.

Die Ansicht der Unterseite 15 des Bedienelements 14 gemäß Fig. 3 zeigt, dass dort zwar grundsätzlich auf einem ähnlichen Kreisring Sensorflächen 22 als ebenfalls kreisringsegmentartige Flächen vorgesehen sind. Allerdings ist hier die Unterteilung feiner und es sind erheblich mehr Sensorflächen 22 vorgesehen, nämlich zehn Stück. Diese Sensorflächen 22 sind per se eigentlich lediglich elektrisch leitfähige Flächen, beispielsweise als Metallplättchen. Diese können in die Unterseite 15 des Bedienelements 14 eingelassen oder eingeformt sein, beispielsweise auch eingespritzt bei einer Herstellung des Bedienelements 14 aus Kunststoff. Sie können mit einer dünnen Abdeckung versehen sein.

Wie aus Fig. 1 zu ersehen ist, sind die Flächen als Sensorflächen 22 über elektrische Verbindungen 23, die hier punktiert innerhalb des Bedienelements 14 verlaufend dargestellt sind, mit auf der Oberseite 16 angeordneten, ebenfalls kreisringsegmentartig ausgebildeten Berührungsflächen 24 verbunden. Ähnlich wie die Sensorflächen 22 können die Berührungsflächen 24 als Metallplättchen ausgebildet sein, beispielsweise aus entsprechend geeignetem Edelstahl odgl. für eine Verwendung im Küchenbereich. Auch sie können eine Abdeckung oder Beschichtung aufweisen. Durch die elektrischen Verbindungen 23 wird bewirkt, dass das Anlegen eines Fingers 26 auf eine Berührungsfläche 24 so wirkt, wie wenn der Finger auf die entsprechende Sensorfläche 22 gelegt werden würde bzw. mit einer Fläche elektrisch verbunden wäre, die gleich ausgebildet ist wie die Sensorfläche 22 und an derselben Stelle liegt. Die Berührung einer Berührungsfläche 24 beispielsweise mit dem Finger kann also als Berührung einer Sensorfläche 22 angesehen werden. Dies kann wiederum durch die unter der Auflage 22 befindlichen Signalgeber 19 erkannt werden, ähnlich wie dies von sonstigen, kapazitiven Berührungsschaltern bekannt ist, beispielsweise aus der eingangs genannten DE 20 2005 019 978 U1 mit der Durchkopplung.

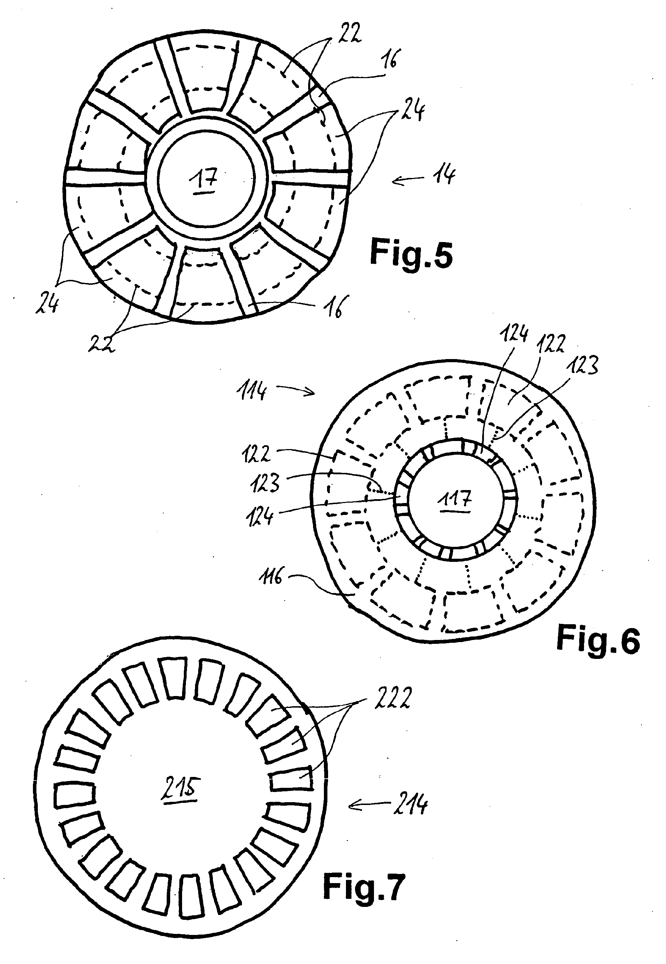

Aus der Darstellung in Fig. 4 ist zu ersehen, wie in einer Stellung die Flächen der Sensorflächen 22 die Flächen der Signalgeber 19 überlappen bzw. zu diesen angeordnet sind. Dabei sind die Signalgeber 19 gestrichelt und schraffiert dargestellt zur besseren Deutlichkeit. Gleichzeitig ist auf punktiert dargestellter Finger 26 aufgelegt, was einer Betätigung oder Berührung an diesem Punkt entspricht. Aus der Überlappung der Sensorfläche 22, die mit der berührten Berührungsfläche verbunden ist, zu dem Signalgeber 19 hin ist zu erkennen, dass der Signalgeber 19 links oben sozusagen überlappt wird und somit dort eine Signal-Änderung von der Steuerung 20 erkannt werden kann. Letztendlich entspricht somit das Berühren der Berührungsfläche 24 links oben mit dem Finger 26 und die Signalübertragung über die Sensorfläche 22 und den entsprechenden Signalgeber 19 auf kapazitivem Weg einer ortsbezogenen Berührung bzw. Betätigung. Damit kann beispielsweise bei einem Kochfeld mit vier im Viereck angeordneten Kochstellen die linke hintere Kochstelle entsprechend der Position des Signalgebers 19 als angewählt gelten, so dass ihre nachfolgende Einstellung, beispielsweise mit der Leistungshöhe, möglich ist. Durch die feinere Aufteilung der Flächen der Sensorflächen 22 bzw. durch das Vorsehen von erheblich mehr Sensorflächen 22 als Signalgebern 19 wird erreicht, dass stets mindestens eine Sensorfläche 22 in etwa in einem für einen Benutzer erkennbaren Bereich über dem Signalgeber 19 liegt für eine dortige Betätigung, also beispielsweise links oben bei der Anordnung gemäß Fig. 4 und 5.

In Fig. 5 ist dargestellt, wie sich die Berührungsflächen 24 jeweils genau oberhalb einer Sensorfläche 22 befinden. Hier ist eine völlige Kongruenz bzw. Überdeckung gegeben. Dies muss jedoch nicht sein, sie können auch jeweils um das gleiche Maß versetzt zueinander sein. Eine gleiche Anzahl von Sensorflächen 22 und Berührungsflächen 24 bietet sich hier auf alle Fälle an.

Gemäß einem ersten vorbeschriebenen Aspekt eines erfindungsgemäßen Bedienverfahrens kann also durch das entsprechend ausgebildete Bedienelement 14 eine ortsgebundene Betätigung bzw. Bedienfunktion durch Auflegen eines Fingers 26 bereitgestellt werden. Des weiteren ist es hier möglich, dass der Finger 26 an dieser Stelle verbleibt beim Drehen des Bedienelements 14. Auch dies kann wiederum von der Steuerung 20 erfasst werden, da sozusagen das durch die Berührung übertragene Signal entsprechend der Drehung über die verschiedenen Signalgeber 19 wandert. Damit kann dann auch eine entsprechende Bedienfunktion verknüpft sein bzw. dadurch ausgelöst werden.

Alternativ zu den in Fig. 1 und 4 dargestellten, im wesentlichen flachen Berührungsflächen 24 können solche mit einer Mulde oder Vertiefung vorgesehen sein. Diese weisen den Vorteil auf, dass ein Finger 26 hineingelegt werden kann in die Vertiefung und das Bedienelement 14 dann lediglich über diesen außen angelegten Finger 26 gedreht wird. Dabei ist gleichzeitig sichergestellt, dass auch stets der elektrische Kontakt vom Finger 26 zur Berührungsfläche 24 gegeben ist, was für die Signalerkennung von Bedeutung ist.

Gemäß einer weiteren Ausgestaltung der Erfindung gemäß Fig. 6 kann ein Bedienelement 114 Berührungsflächen 124 nicht auf seiner Oberseite 116 aufweisen wie in den Fig. 1 und 5, sondern als kreisringsegmentartige Berührungsflächen am Zentralteil 117. Allerdings könnte hierbei noch stärker als bei der Ausführung gemäß Fig. 5 das Problem auftauchen, dass das Bedienelement 14 mit zwei Fingern berührt wird zum sicheren Drehen. Da diese beiden Finger üblicherweise einander gegenüberliegend angesetzt werden zum sicheren Greifen für das Drehen ist hier eine eindeutige Erkennung der Position eines aufgelegten Fingers 26 nicht mehr möglich. Dies kann zwar noch für ein Bedienverfahren genutzt werden, welches das Anlegen eines Fingers überhaupt an einen der Berührungsflächen erkennt und entsprechend auswertet, beispielsweise für eine im Vergleich zu ohne Berührung erfolgten Drehung andere Bedienfunktion. Eine vorgenannte spezielle Bedienfunktion über die geometrische Zuordnung des Auflegens eines Fingers 26 ist dann allerdings nicht mehr möglich.

Es könnte jedoch vorgesehen sein, dass eine Bedienperson zum Drehen des Bedienelements 114, wie im übrigen unter Umständen auch desjenigen aus den Fig. 1 und 5, mit einem Finger 126 an der gewünschten Stelle an eine der Berührungsflächen 124 des Zentralteils 117 greift und mit dem anderen Finger an die Oberseite 16, ohne damit eine zweite Berührungsfläche 124 zu berühren. Dann ist wieder die geometrische Auswertung möglich.

Eine nochmals weitere Ausgestaltung der Erfindung ist aus Fig. 7 zu ersehen. Dort ist im Vergleich zu der Fig. 3 eine doppelt so feine Unterteilung der Sensorflächen 122 vorgesehen, also zwanzig Sensorflächen 222. Dies ermöglicht eine noch feinere Auswertung des Orts des Auflegens eines Fingers auf einen Berührungsbereich oben an dem Bedienelement 214. Es kann auch ein Fall gemäß der Fig. 1 bis 3 vermieden werden, in dem ein Finger genau auf zwei nebeneinanderliegende Berührungsflächen gelegt wird und diese beispielsweise so zwischen zwei Signalgebern liegen, dass nicht genau ausgewertet werden kann, an welchem der Finger näher dran ist.

Des weiteren ist es bei den hier dargestellten Ausbildungen der Bedienelemente auch möglich, dass zum Drehen des Bedienelements eine Berührungsfläche überhaupt nicht mehr berührt sein muss, sondern lediglich einmal am Anfang für eine bestimmte auszulösende Funktion oder einen sogenannten Funktions- oder Betätigungsmodus. Ob dann die Berührung weiterhin aufrecht erhalten wird oder nicht, insbesondere an genau dieser Berührungsfläche, oder zu einer anderen Berührungsfläche hin wechselt spielt keine Rolle mehr. Die erste Berührung zählt hier. Des weiteren ist es für den Fachmann klar, dass zahlreiche Aspekte der genannten Merkmale eines Bedienverfahrens miteinander günstig kombiniert werden können für ein vorteilhaftes Bedienverfahren.

## Patentansprüche

1. Bedienvorrichtung (11) für ein Elektrogerät, vorzugsweise ein E-lektrowärmegerät wie ein Kochfeld (12), wobei die Bedienvorrichtung ein Bedienelement (14, 114, 214) aufweist, das bewegbar und abnehmbar mit einer Bedienelement-Unterseite (15, 215) auf einer Auflage (12) aufliegt, mit einer berührungslosen Signalkopplung zwischen Signalgebern (19, 119, 219) an oder unter der Auflage und Sensorflächen (22, 122, 222) an dem Bedienelement (14, 114, 214), wobei die Sensorflächen mit Berührungsflächen (24, 124, 224) gekoppelt sind, die von einer Bedienperson berührbar bzw. bedienbar sind für eine Bedienfunktion und dies durch die Signalkopplung an den Signalgebern (19, 119, 219) feststellbar ist, wobei mehrere Signalgeber und mehrere Sensorflächen entlang jeweils entsprechender konzentrischer Kreise an Auflage und Bedienelement (14, 114, 214) angeordnet sind, **dadurch gekennzeichnet, dass** mehr Sensorflächen (22, 122, 222) als Signalgeber (19, 119, 219) vorgesehen sind.

2. Bedienvorrichtung nach Anspruch 1, **dadurch gekennzeichnet, dass** mehr als doppelt so viele Sensorflächen (22, 122, 222) wie Signalgeber (19, 119, 219) vorgesehen sind, wobei vorzugsweise mindestens zwölf Sensorflächen vorgesehen sind.

3. Bedienvorrichtung nach Anspruch 1 oder 2, **dadurch gekennzeichnet, dass** die Sensorflächen (22, 122, 222) und/oder die Signalgeber (19, 119, 219) jeweils gleich verteilt sind mit gleichen Abständen zueinander.

4. Bedienvorrichtung nach einem der vorhergehenden Ansprüche, **dadurch gekennzeichnet, dass** die Kreise mit den Sensorflächen (22, 122, 222) und Signalgebern (19, 119, 219) gleich groß sind und jeweils übereinanderliegen.

5. Bedienvorrichtung nach einem der vorhergehenden Ansprüche, **dadurch gekennzeichnet, dass** die Sensorflächen (22, 122, 222) entlang eines Kreises etwas innerhalb des Außenumfangs des Bedienelements (14, 114, 214) angeordnet sind.

6. Bedienvorrichtung nach einem der vorhergehenden Ansprüche, **gekennzeichnet durch** eine kapazitive Signalkopplung zwischen den Sensorflächen (22, 122, 222) und den Signalgebern (19, 119, 219), wobei vorzugsweise die Sensorflächen über die jeweils zugeordneten Berührungsflächen (24, 124, 224) am Bedienelement (14, 114, 214) **durch** einen das Bedienelement berührenden Finger (26) einer Bedienperson elektrisch kontaktierbar sind, und diese Berührung von den Signalgebern (19, 119, 219) erkennbar ist.

7. Bedienvorrichtung nach einem der vorhergehenden Ansprüche, **dadurch gekennzeichnet, dass** die Berührungsflächen (24, 124, 224) am Bedienelement (14, 114, 214) elektrisch leitfähig und direkt mit den Sensorflächen (22, 122, 222) an der Bedienelement-Unterseite verbunden sind, wobei die Sensorflächen die Signalkopplung zu den Signalgebern (19, 119, 219) bewirken, und wobei vorzugsweise pro Sensorfläche (22, 122, 222) eine Berührungsfläche (24, 124, 224) vorgesehen ist.

8. Bedienvorrichtung nach einem der vorhergehenden Ansprüche, **dadurch gekennzeichnet, dass** die elektrisch leitfähige Verbindung zwischen den Sensorflächen (22, 122, 222) und den Berührungsflächen (24, 124, 224) innerhalb des Bedienelements (14, 114, 214) verläuft, vorzugsweise eingespritzt ist.

9. Bedienvorrichtung nach einem der vorhergehenden Ansprüche, **dadurch gekennzeichnet, dass** die Sensorflächen (222) und die Berührungsflächen (224) schmale Streifen sind, die in radialer Richtung verlaufen.

10. Bedienvorrichtung nach dem Oberbegriff des Anspruchs 1, **dadurch gekennzeichnet, dass** an bzw. unter der Auflage (12) ein Signalgeber in Form eines kapazitiven Sliders in Kreisringform angeordnet ist.

11. Verfahren zum Bedienen einer Bedienvorrichtung (11) nach einem der vorhergehenden Ansprüche, **dadurch gekennzeichnet, dass** bei einem Kochfeld (12) mit mehreren Kochstellen als Elektrogerät zuerst eine der Berührungsflächen (24, 124, 224) berührt bzw. betätigt wird zur Auswahl einer Kochstelle und danach durch Bewegen des Bedienelements (14, 114, 214) eine Leistungsstufe, Betriebsdauer oder Betriebsverzögerung für diese Kochstelle eingestellt wird.

12. Verfahren nach Anspruch 11, **dadurch gekennzeichnet, dass** beim Bewegen des Bedienelements (14, 114, 214) zum Einstellen der Leistungshöhe die Berührungsfläche (24, 124, 224) zum Auswählen der Kochstelle weiterhin berührt bzw. betätigt bleibt durch einen aufgelegten Finger (26).

13. Verfahren nach Anspruch 11, **dadurch gekennzeichnet, dass** beim Bewegen des Bedienelements (14, 114, 214) zum Einstellen der Leistungshöhe die Berührungsfläche (24, 124, 224) zum Auswählen der Kochstelle nicht mehr berührt bzw. betätigt ist.

## Claims

1. A control device (11) for an electrical appliance, preferably an electrical heating appliance such as a hob (12), the control device comprising a control element (14, 114, 214), which rests movably and removably with its control element bottom (15, 215) on a support (12), with contactless signal coupling between signal transmitters (19, 119, 219) on or under the support and sensor surfaces (22, 122, 222) on the control element (14, 114, 214), the sensor surfaces being coupled to touch-sensitive surfaces (24, 124, 224), which may be touched or operated by an operator for a control function, this being detectable by the signal coupling to the signal transmitters (19, 119, 219), a plurality of signal transmitters and a plurality of sensor surfaces being arranged in each case in corresponding concentric circles on the support and the control element (14, 114, 214), **characterised in that** more sensor surfaces (22, 122, 222) are provided than signal transmitters (19, 119, 219).

2. A control device according to claim 1, **characterised in that** more than twice as many sensor surfaces (22, 122, 222) as signal transmitters are provided (19, 119, 219), preferably at least twelve sensor surfaces being provided.

3. A control device according to claim 1 or claim 2, **characterised in that** the sensor surfaces (22, 122, 222) and/or the signal transmitters (19, 119, 219) are in each case evenly distributed with identical distances between them.

4. A control device according to any one of the preceding claims, **characterised in that** the circles with the sensor surfaces (22, 122, 222) and signal transmitters (19, 119, 219) are of identical size and are superimposed one over the other.

5. A control device according to any one of the preceding claims, **characterised in that** the sensor surfaces (22, 122, 222) are arranged in a circle somewhat to the inside of the outer circumference of the control element (14, 114, 214).

6. A control device according to any one of the preceding claims, **characterised by** capacitive signal coupling between the sensor surfaces (22, 122, 222) and the signal transmitters (19, 119, 219), the sensor surfaces preferably being electrically contactable via the in each case associated touch-sensitive surfaces (24, 124, 224) on the control element (14, 114, 214) by an operator's finger (26) touching the control element, and this touch is detectable by the signal transmitters (19, 119, 219).

7. A control device according to any one of the preceding claims, **characterised in that** the touch-sensitive surfaces (24, 124, 224) on the control element (14, 114, 214) are connected electrically conductively and directly to the sensor surfaces (22, 122, 222) on the bottom of the control element, the sensor surfaces effecting signal coupling to the signal transmitters (19, 119, 219) and one touch-sensitive surface (24, 124, 224) preferably being provided per sensor surface (22, 122, 222).

8. A control device according to any one of the preceding claims, **characterised in that** the electrically conductive connection between the sensor surfaces (22, 122, 222) and the touch-sensitive surfaces (24, 124, 224) extends within the control element (14, 114, 214), preferably is injection-moulded therein.

9. A control device according to any one of the preceding claims, **characterised in that** the sensor surfaces (222) and the touch-sensitive surfaces (224) are narrow strips, which extend radially.

10. A control device according to the precharacterising clause of claim 1, **characterised in that** a signal transmitter in the form of a capacitive slider is arranged in the form of a circular ring on or under the support (12).

11. A method of operating a control device (11) according to any one of the preceding claims, **characterised in that** in the case of an electrical appliance in the form of a hob (12) with a plurality of hotplates, firstly one of the touch-sensitive surfaces (24, 124, 224) is touched or actuated to select a hotplate and then, by moving the control element (14, 114, 214), a power stage, operating time or operating delay is set for this hotplate.

12. A method according to claim 11, **characterised in that**, when moving the control element (14, 114, 214) to set the power level, the touch-sensitive surface (24, 124, 224) remains touched or actuated by a finger (26) laid thereon to select the hotplate.

13. A method according to claim 11, **characterised in that**, when moving the control element (14, 114, 214) to set the power level, the touch-sensitive surface (24, 124, 224) is no longer touched or actuated to select the hotplate.

## Revendications

1. Dispositif de commande (11) pour un appareil électrique, de préférence un appareil de chauffage électrique tel qu'une plaque de cuisson (12), sachant que le dispositif de commande présente un élément de commande (14, 114, 214) qui repose de manière mobile et amovible sur un support (12) par une face inférieure (15, 215) de l'élément de commande, avec un couplage de signaux sans contact entre d'une part les émetteurs de signaux (19, 119, 219) sur ou sous le support et d'autre part les surfaces de détection (22, 122, 222) sur l'élément de commande (14, 114, 214), sachant que les surfaces de détection sont couplées à des surfaces de contact (24, 124, 224) qui peuvent être touchées ou actionnées par un utilisateur pour exécuter une fonction d'utilisation et que cela peut être détecté par le couplage de signaux aux émetteurs de signaux (19, 119, 219), plusieurs émetteurs de signaux et plusieurs surfaces de détection étant disposés respectivement le long de cercles concentriques correspondants sur le support et l'élément de commande (14, 114, 214), **caractérisé en ce que** sont prévues plus de surfaces de détection (22, 122, 222) que d'émetteurs de signaux (19, 119, 219).

2. Dispositif de commande selon la revendication 1, **caractérisé en ce que** sont prévues plus de deux fois plus de surfaces de détection (22, 122, 222) que d'émetteurs de signaux (19, 119, 219), sachant que sont prévues de préférence au moins douze surfaces de détection.

3. Dispositif de commande selon la revendication 1 ou 2, **caractérisé en ce que** les surfaces de détection (22, 122, 222) et/ou les émetteurs de signaux (19, 119, 219) sont respectivement répartis de manière identique à équidistance.

4. Dispositif de commande selon l'une des revendications précédentes, **caractérisé en ce que** les cercles avec les surfaces de détection (22, 122, 222) et les émetteurs de signaux (19, 119, 219) sont de même taille et placés respectivement les uns au dessus des autres.

5. Dispositif de commande selon l'une des revendications précédentes, **caractérisé en ce que** les surfaces de détection (22, 122, 222) sont disposées le long d'un cercle légèrement à l'intérieur de la circonférence extérieure de l'élément de commande (14, 114,214).

6. Dispositif de commande selon l'une des revendications précédentes, **caractérisé par** un couplage capacitif de signaux entre les surfaces de détection (22, 122, 222) et les émetteurs de signaux (19, 119, 219), sachant que les surfaces de détection peuvent de préférence être mises en contact électrique via les surfaces de contact (24, 124, 224) respectivement attribuées sur l'élément de commande (14, 114, 214) lors du contact d'un doigt (26) de l'utilisateur avec l'élément de commande, et que ce contact peut être reconnu par les émetteurs de signaux (19, 119, 219).

7. Dispositif de commande selon l'une des revendications précédentes, **caractérisé en ce que** les surfaces de contact (24, 124, 224) sur l'élément de commande (14, 114, 214) sont conductrices d'électricité et sont reliées directement aux surfaces de détection (22, 122, 222) sur la face inférieure de l'élément de commande, sachant que les surfaces de détection permettent le couplage de signaux avec les émetteurs de signaux (19, 119, 219), et qu'une surface de contact (24, 124, 224) est de préférence prévue par surface de détection (22, 122, 222).

8. Dispositif de commande selon l'une des revendications précédentes, **caractérisé en ce que** la liaison conductrice d'électricité entre les surfaces de détection (22, 122, 222) et les surfaces de contact (24, 124, 224) s'étend à l'intérieur de l'élément de commande (14, 114, 214), de préférence par injection.

9. Dispositif de commande selon l'une des revendications précédentes, **caractérisé en ce que** les surfaces de détection (222) et les surfaces de contact (224) sont des bandes étroites qui s'étendent dans le sens radial.

10. Dispositif de commande selon le préambule de la revendication 1, **caractérisé en ce qu'**est disposé sur ou sous le support (12) un émetteur de signaux sous forme d'un coulisseau capacitif en forme d'anneau de cercle.

11. Procédé de commande d'un dispositif de commande (11) selon l'une des revendications précédentes, **caractérisé en ce que**, si l'appareil électrique est une plaque de cuisson (12) présentant plusieurs zones de cuisson, une des surfaces de contact (24, 124, 224) est tout d'abord touchée / actionnée pour sélectionner une zone de cuisson, puis un niveau de puissance, une durée de fonctionnement ou un fonctionnement temporisé pour cette zone de cuisson sont ensuite réglés en déplaçant l'élément de commande (14, 114, 214).

12. Procédé selon la revendication 11, **caractérisé en ce que** pendant le déplacement de l'élément de commande (14, 114, 214) pour régler le niveau de puissance, la surface de contact (24, 124, 224) reste en contact ou actionnée par un doigt (26) appliqué sur celle-ci pour choisir la zone de cuisson.

13. Procédé selon la revendication 11, **caractérisé en ce que** pendant le déplacement de l'élément de commande (14, 114, 214) pour régler le niveau de puissance, la surface de contact (24, 124, 224) n'est plus en contact ou actionnée pour désélectionner la zone de cuisson.
